Europäisches Patentamt

European Patent Office

Office européen des brevets

(19)

(11) EP 0 731 609 A2

(12) DEMANDE DE BREVET EUROPEEN

(43) Date de publication:
11.09.1996 Bulletin 1996/37

(51) Int Cl.⁶: **H04N 7/28**, H03M 7/30

(21) Numéro de dépôt: 96460007.6

(22) Date de dépôt: 06.02.1996

(84) Etats contractants désignés:
DE GB IT

(30) Priorité: 09.02.1995 FR 9501688

(71) Demandeurs:
• FRANCE TELECOM
75015 Paris (FR)
• TELEDIFFUSION DE FRANCE
75015 Paris (FR)

(72) Inventeurs:
• Guillemot, Christine
F-35000 Rennes (FR)
• Onno, Patrice
F-35510 Cesson-Sevigne (FR)

(74) Mandataire: Maillet, Alain
Cabinet Le Guen & Maillet,
38, rue Levavasseur,
B.P. 91
35802 Dinard Cedex (FR)

(54) **Procédé de quantification vectorielle sur réseau contrainte en débit**

(57)    La présente invention concerne un procédé de quantification vectorielle sur réseau contrainte en débit, ledit procédé consistant à associer à un ensemble de points représentatifs de grandeurs caractéristiques d'un signal à quantifier un ensemble de points d'un réseau, dits points quantifiés, les coordonnées polaires de chacun desdits points quantifiés étant associées à un code.

Il est caractérisé en ce qu'il consiste à déterminer, parmi les points du réseau se trouvant dans un voisinage prédéterminé de chaque point quantifié, celui qui fournit le meilleur compromis exprimé en une relation prédéterminée entre la distorsion $\underline{d}$ résultant de la quantification dudit point quantifié et le débit $\underline{r}$ déterminé à partir de la longueur dudit code affecté audit point quantifié, et à retenir, comme points quantifiés pour le codage, ceux qui correspondent auxdits points déterminés.

FIG. 6

## Description

La présente invention concerne un procédé de quantification vectorielle sur réseau contrainte en débit.

La technique de quantification vectorielle sur réseau est bien connue et est utilisée notamment dans des systèmes de compression de signaux vidéo ou audio.

Bien que le procédé de l'invention puisse trouver application dans tous les domaines où la fonction de quantification est essentielle, la présente description n'envisage que le cas de quantification de signaux d'images. On notera que dans ce domaine particulier, le procédé de l'invention peut s'appliquer tant pour le codage et la transmission de signaux de télévision conventionnelle et de signaux de télévision haute définition que pour des applications à très bas débits dont les techniques de codage vont faire prochainement l'objet de travaux de normalisation.

On considérera ainsi, à titre d'exemple, que les signaux d'images sont décomposés en un certain nombre de sous-signaux d'image, tels que des sous-bandes et le procédé de quantification selon l'invention s'applique sur les signaux de chacune des sous-images. Dans la suite de la description, les termes de "sous-signal" et "sous-bande" sont confondus au profit du terme "sous-bande", mais on comprendra que l'invention s'applique de manière générale à des signaux décomposés en sous-signaux, quelque soit le processus aboutissant à cette décomposition.

Le procédé de l'invention peut être utilisé tant pour le codage de signaux dits, dans le domaine de la technique, "signaux *intra*" que pour le codage de signaux dits "signaux d'erreur de prédiction". Dans ce dernier cas, cette utilisation est indépendante de la technique utilisée pour le calcul du signal de prédiction, par exemple calcul à base d'algorithmes classiques d'estimation et de compensation de mouvement, du type "block matching" ou "quadtree" contraint en débit, ou à base d'algorithmes plus élaborés reposant sur la segmentation en région.

La quantification vectorielle sur réseau est l'extension multidimensionnelle de la quantification scalaire uniforme. Cette dernière consiste à quantifier séparément chaque pixel d'une image en $2^N$ niveaux où N est le nombre de bits alloués au quantificateur. Le pas de quantification $q$ est choisi uniforme. La quantification consiste essentiellement à ramener toutes les valeurs respectivement prises, pour chaque pixel, par les signaux d'images dans les sous-bandes les composant dans l'intervalle $[0, 2^N - 1]$, ceci par transformation linéaire de la forme $ax + b$ où $a$ et $b$ sont calculés en fonction du nombre N de bits par pixel alloués au quantificateur et des valeurs maximales et minimales que peuvent prendre lesdites valeurs dans les sous-bandes, et à ramener les valeurs obtenues par ladite transformation aux entiers les plus proches de l'intervalle $[0, 2^N - 1]$.

La quantification vectorielle sur réseau est associée à un réseau régulier et permet de quantifier en un point dudit réseau dans un espace de dimension $\underline{n}$ un vecteur dont les composantes sont les valeurs prises par les signaux d'images dans une sous-bande donnée pour un groupement de $\underline{n}$ pixels donné. A chaque vecteur de pixel est associé un point de l'espace que l'on appellera par la suite le point à quantifier. Pour ce faire, on détermine le volume dans lequel se trouvent les vecteurs puis on ramène par un facteur d'échelle, ou quantificateur, appliqué à chaque groupement de pixels l'ensemble des vecteurs de chaque sous-bande dans un volume contenant à peu près $2^{nR}$ points du réseau où R est le débit souhaité. Enfin, pour chaque vecteur d'une sous-bande, on détermine, au moyen d'un algorithme, le point du réseau le plus proche et ceci pour l'ensemble des vecteurs de chaque sous-bande. A partir des coordonnées du point de réseau ainsi déterminé, on effectue un codage.

De manière générale, la quantification d'un vecteur engendre une distorsion qui résulte de l'éloignement entre le point à quantifier et le point du réseau. Cet éloignement peut être formalisé par une fonction mathématique telle que l'erreur quadratique moyenne. Dans ce cas, la distorsion est représentée par la distance qui sépare le point à quantifier du point du réseau. Dans les techniques existantes, une fois choisie la structure du réseau, on effectue la projection du vecteur sur le point du réseau le plus proche puis on recherche le quantificateur optimal, c'est-à-dire celui qui minimise la distorsion globale dans les sous-bandes.

Pour minimiser cette distorsion, on détermine le réseau de quantification optimal pour chaque signal à quantifier, c'est-à-dire le réseau fournissant la distorsion globale minimale étant donné un débit total Rd. Cette minimisation s'effectue sur un ensemble de N quantificateurs se distinguant les uns des autres par des facteurs d'échelle différents appliqués aux signaux à quantifier. Pour résoudre ce problème, on peut utiliser l'algorithme qui est décrit par Kannan Ramchandran et Martin Vetterli dans un article intitulé "Best Wavelet Packet Bases in a Rate-Distortion Sense" et paru dans la revue IEEE TRANSACTIONS ON IMAGE PROCESSING, vol 2, No 2, d'avril 1993. Cet algorithme se décompose en trois étapes successives.

Dans une première étape, on calcule, pour chaque vecteur et pour chaque quantificateur, la distorsion et le débit correspondant afin d'obtenir, dans un plan débit-distorsion, un nuage de points. Les valeurs de distorsion sont par exemple calculées en utilisant l'algorithme de quantification décrit par J.H. Conway et N.J.A. Sloane dans un article intitulé "Fast Quantizing and Decoding Algorithms for Lattice Quantizers and Codes" et paru dans IEEE trans. on Information Theory, 28(2), mars 1992. Les valeurs de débit sont obtenues en utilisant une procédure de codage entropique du type "codage d'Huffman". On notera que le nombre de quantificateurs détermine le nombre de volumes dans lesquels sont projetés les vecteurs à quantifier ainsi que la finesse du pas entre débits voisins.

Dans une seconde étape on recherche l'enveloppe convexe du nuage de points obtenus à l'étape précédente.

Enfin, dans une troisième étape, on effectue une recherche sur l'enveloppe seule pour obtenir le point le plus proche du débit souhaité Rd. Ce point est celui qui fournit la plus petite distorsion avec un débit inférieur ou égal au débit souhaité.

L'idée maîtresse de ce procédé repose sur la recherche des quantificateurs optimaux permettant d'obtenir la distorsion la plus faible possible pour un débit donné.

Le but de l'invention est d'améliorer encore le procédé qui vient d'être décrit et donc de proposer un procédé de quantification vectorielle sur réseau qui permette de diminuer la distorsion globale des signaux codés pour un débit donné.

L'idée qui est la base de l'invention est la constatation du fait que la quantification réalisée dans les approches connues ne tient pas compte du coût de codage d'un vecteur par rapport à un autre.

En effet, une fois l'opération de quantification effectuée, il faut transmettre un code pour chaque vecteur. Dans la plupart des situations rencontrées en codage d'images, les densités de probabilités des vecteurs suivent des lois de Gauss ou des lois de Gauss généralisées. Ces lois sont caractérisées par une probabilité forte à l'origine et fortement décroissante ensuite. Il est alors préférable de coder un vecteur en séparant le code en deux parties et faire une représentation polaire du vecteur. Ainsi, le vecteur est codé grâce à un code produit formé d'un code pour la norme et d'un code pour la phase. Ces codes sont attribués par des codages entropiques effectués selon, par exemple, l'algorithme d'Huffman".

Les densités de points sur les isonormes adjacentes qui résultent de la projection des vecteurs sur les points du réseau ne varient pas de façon uniforme avec la norme. On appelle une isonorme, une surface qui est engendrée par les points du réseau qui ont même norme. En outre, plus une isonorme est dense et plus la longueur moyenne du code de phase est importante.

Il résulte de ces considérations que le code affecté au point du réseau le plus proche du point à quantifier peut être plus long que celui qui serait affecté à un autre point du réseau plus éloigné. On dit que le coût de codage du premier vecteur est supérieur à celui du second.

D'autres considérations que celles qui sont mentionnées ci-dessus peuvent grever le coût de codage d'un vecteur.

Le but de l'invention est donc de prévoir un procédé de quantification vectorielle sur réseau qui permette de diminuer la distorsion globale des signaux codés pour un débit donné et qui, de plus, tienne compte non seulement de la distorsion mais également du coût de codage des vecteurs quantifiés.

Afin d'atteindre les buts mentionnés ci-dessus, un procédé selon l'invention est du type qui consiste à associer à un ensemble de points représentatifs de grandeurs caractéristiques d'un signal à quantifier un ensemble de points d'un réseau, dits points quantifiés, les coordonnées polaires de chacun desdits points quantifiés étant associées à un code.

Selon une caractéristique de l'invention, il consiste à déterminer, parmi les points du réseau se trouvant dans un voisinage prédéterminé de chaque point quantifié, celui qui fournit le meilleur compromis exprimé en une relation prédéterminée entre la distorsion d résultant de la quantification dudit point quantifié et le débit r déterminé à partir de la longueur dudit code affecté audit point quantifié, et à retenir, comme points quantifiés pour le codage, ceux qui correspondent auxdits points déterminés.

La présente invention est encore un procédé de quantification vectorielle sur réseau contrainte en débit, du type consistant:

a) à associer à un ensemble de points représentatifs de grandeurs caractéristiques d'un signal à quantifier une pluralité d'ensembles de points, les points desdits ensembles appartenant respectivement à une pluralité de réseaux,
b) à déterminer, parmi la pluralité de réseaux, celui qui minimise la distorsion globale résultant de la quantification sous contrainte d'un débit global prédéterminé,
c) à retenir comme points quantifiés ceux qui forment l'ensemble de points appartenant audit réseau ainsi déterminé à l'étape b), et
d) à former un code par codage des coordonnées polaires de chacun desdits points quantifiés.

Selon une caractéristique de l'invention, il consiste encore:

e) à déterminer, parmi les points du réseau se trouvant dans un voisinage prédéterminé de chaque point quantifié, celui qui minimise la fonction objective suivante:

$d + \lambda_{opt}\, r$ où $\underline{d}$ est la distorsion résultant de la quantification dudit point quantifié, $\underline{r}$ le débit obtenu à partir de la longueur du code affecté audit point quantifié et $\lambda_{opt}$ la constante de Lagrange déterminée lors de l'étape b), et
f) à retenir comme points quantifiés ceux qui correspondent auxdits points déterminés à l'étape e).

Selon une variante de réalisation, il consiste encore:

e) à déterminer, parmi les points du réseau se trouvant dans un voisinage prédéterminé de chaque point quantifié, celui qui minimise la fonction objective suivante:

$d + \lambda_{opt}\, r$ où $\underline{d}$ est la distorsion résultant de la

quantification, $\underline{r}$ le débit obtenu à partir de la longueur du code affecté audit point quantifié et $\lambda_{opt}$ la constante de Lagrange déterminée lors du processus de minimisation de la distorsion globale sous contrainte dudit débit global prédéterminé,

f) à retenir comme points quantifiés ceux qui correspondent auxdits points déterminés à l'étape e),

g) à recalculer la constante de Lagrange $\lambda_{opt}$ afin de minimiser la distorsion globale sous contrainte d'un débit global augmenté d'une quantité prédéterminée, et

h) à recommencer les étapes e), f) et g) jusqu'à ce que le débit global obtenu soit égal au débit global désiré.

Avantageusement, ledit signal à quantifier est subdivisé en une pluralité de sous-signaux.

La présente invention concerne également un procédé de quantification vectorielle sur réseau contrainte en débit, du type consistant:

a) à associer à un ensemble de points représentatifs de grandeurs caractéristiques de chacun desdits signaux du signal à quantifier une pluralité d'ensembles de points, les points desdits ensembles appartenant respectivement à une pluralité de réseaux,

b) à déterminer, parmi les réseaux de projection des sous-signaux, ceux qui minimisent la distorsion globale résultant de la quantification sous contrainte d'un débit global prédéterminé,

c) à retenir comme points quantifiés ceux qui forment les ensembles de points appartenant auxdits réseaux ainsi déterminés à l'étape b), et

d) à former un code par codage des coordonnées polaires de chacun desdits points quantifiés.

Selon une caractéristique de l'invention, il consiste encore:

e) à déterminer, parmi les points du réseau se trouvant dans un voisinage prédéterminé de chaque point quantifié, celui qui minimise la fonction objective suivante:

$d + \lambda_{opt} r$ où $\underline{d}$ est la distorsion résultant de la quantification dudit point quantifié, $\underline{r}$ le débit obtenu à partir de la longueur du code affecté audit point quantifié et $\lambda_{opt}$ la constante de Lagrange déterminée lors de l'étape b), et

f) à retenir comme points quantifiés ceux qui correspondent auxdits points déterminés à l'étape e).

Selon une variante, il consiste:

e) à déterminer, parmi les points du réseau se trouvant dans un voisinage prédéterminé de chaque point quantifié, celui qui minimise la fonction objective suivante:

$d + \lambda_{opt} r$ où $\underline{d}$ est la distorsion résultant de la quantification, $\underline{r}$ le débit obtenu à partir de la longueur du code affecté audit point quantifié et $\lambda_{opt}$ la constante de Lagrange déterminée lors du processus de minimisation de la distorsion globale sous contrainte dudit débit global prédéterminé,

f) à retenir comme points quantifiés ceux qui correspondent auxdits points déterminés à l'étape e),

g) à recalculer la constante de Lagrange $\lambda_{opt}$ afin de minimiser la distorsion globale sous contrainte d'un débit global augmenté d'une quantité prédéterminée, et

h) à recommencer les étapes e), f) et g) jusqu'à ce que le débit global obtenu soit égal au débit global désiré.

Selon une caractéristique de l'invention, pour le processus de minimisation de la distorsion globale sous contrainte du débit global, on effectue une pondération de la distorsion $\underline{d}$ affectée à chaque point quantifié différente selon que le point est représentatif d'un sous-signal ou d'un autre sous-signal.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels:

la Fig. 1 est un diagramme montrant les différentes étapes d'un procédé de quantification vectorielle sur réseau selon l'invention,

la Fig. 2 est un tableau montrant des longueurs de codes obtenus pour une quantification de 90 vecteurs sur un réseau $D_4$ de norme $L_2$,

les Figs. 3a à 3c montrent chacune la distorsion en fonction du débit dans chaque sous-bande d'un signal à quantifier,

la Fig. 4 montre la distorsion globale en fonction du débit global afin d'illustrer l'étape de minimisation de la distorsion globale contrainte sous un débit global prédéterminé,

les Figs. 5a et 5b illustrent l'étape du procédé de quantification qui fait l'objet de la présente invention, et

la Fig. 6 est une courbe qui montre le rapport signal sur bruit en fonction du débit et qui illustre une caractéristique du procédé selon l'invention.

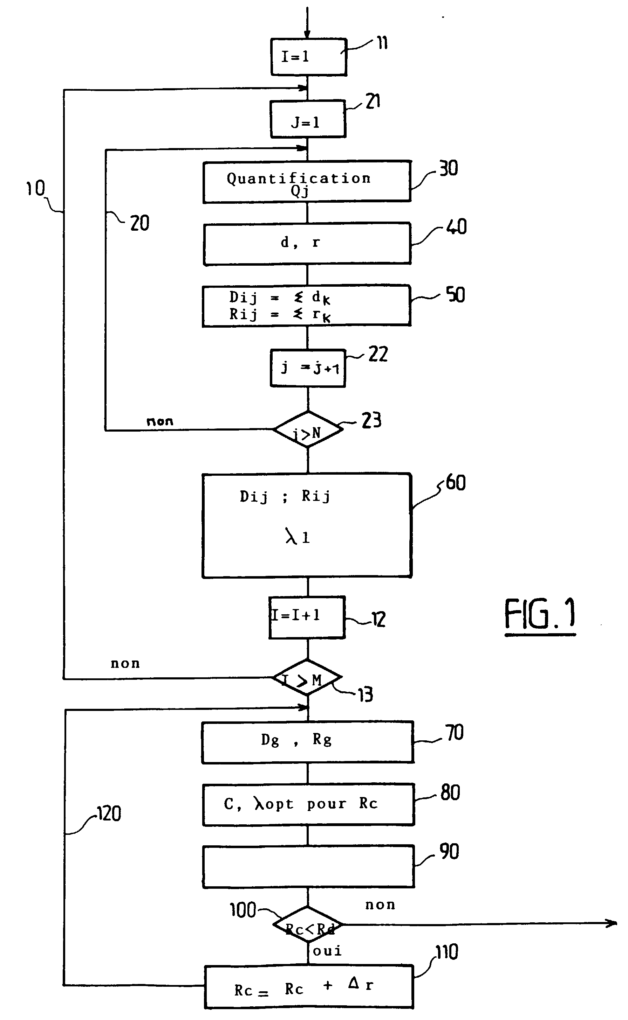

Le diagramme de la Fig. 1 illustre donc un procédé de quantification selon l'invention.

On peut constater la présence de deux boucles 10 et 20 incluant respectivement des compteurs initialisés aux étapes 11 et 21 et incrémentés aux étapes 12 et 22 ainsi que des comparateurs 13 et 23. La première boucle 10 porte sur les sous-bandes SB d'indice i et au nombre de M, alors que la seconde boucle 20 porte sur les quantificateurs Q d'indice j et au nombre de N.

Une fois les compteurs initialisés aux étapes 11 et 21, dans une première étape 30, on recherche, pour chaque point de l'image à quantifier de la sous-bande $SB_i$, le point du réseau de quantification défini par un quantificateur $Q_j$ qui est le plus proche du vecteur associé à ce point et à cette sous-bande $SB_i$.

La quantification réalisée ici est une quantification vectorielle s'appliquant sur tout type de réseaux. Ces réseaux peuvent être, par exemple, un réseau du type $A_n$, ($A_2$, $A_3$, ...), un réseau de type $D_n$ ($D_4$, $D_8$, ...) , du type $E_n$, ($E_4$, $E_8$, ...) ou du type $\Lambda_n$ ($\Lambda_{16}$, ...). Pour la détermination du point le plus proche pour chaque point dans chaque sous-bande $SB_i$, on pourra se reporter notamment à l'article écrit par J.H. Conway et N.J.A. Sloane intitulé "Fast quantizing and decoding algorithms for lattice quantizers and codes" paru dans IEEE Trans. on Information Theory, 28(2), de mars 1992.

Dans une seconde étape 40, on calcule, pour le vecteur associé à chaque point du réseau déterminé à la première étape 30, la distorsion d engendrée par l'approximation résultant de la quantification et le débit r résultant du codage des coordonnées du point du réseau précédemment déterminé.

La distorsion d pour chaque point et pour chaque sous-bande $SB_i$ est calculée en considérant la distance définie ici comme l'erreur quadratique moyenne ou pondérée qui sépare le point quantifié déterminé du point à quantifier.

Le codage du point quantifié est effectué selon une représentation polaire, c'est-à-dire selon un code produit formé d'un code de norme et d'un code de phase. Pour chaque point, les codes de norme et de phase sont des codes entropiques, tels que des codes d'"Huffman". La norme utilisée peut être du type $L_1$ ou $L_2$, les isonormes étant alors respectivement des hyperpyramides ou des hypersphères.

Le débit r est déduit de la longueur des codes respectivement affectés aux points quantifiés.

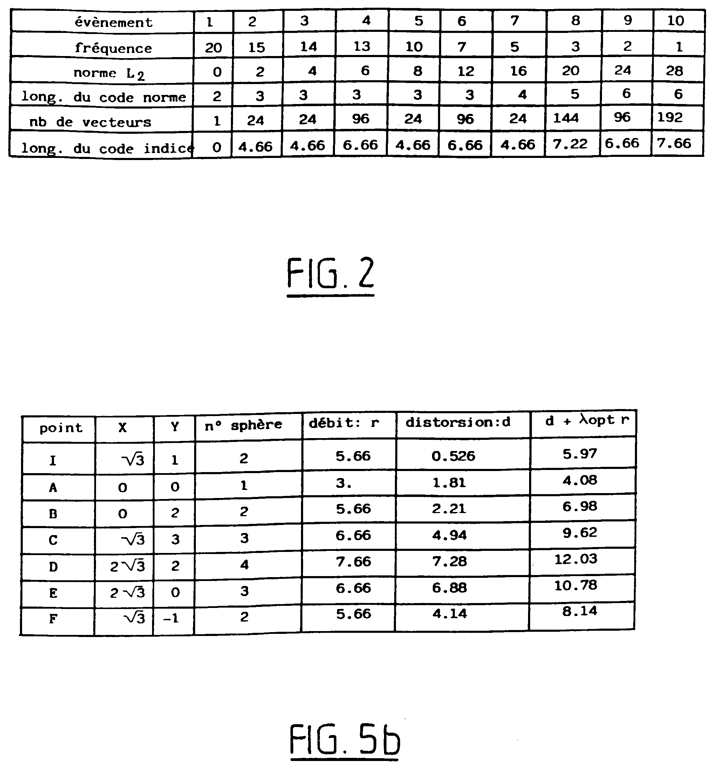

A la Fig. 2, on a représenté un tableau donnant les caractéristiques de 90 vecteurs qui, après quantification sur un réseau $D_4$ de norme $L_2$ suivent une distribution statistique donnée (voir ligne fréquence). Les longueurs de code, exprimées en bits et attribuées pour le code de norme ont été obtenues à partir d'un algorithme de Huffman sur les 10 événements différents. La quatrième ligne donne la longueur du code de norme. La cinquième ligne donne le nombre de vecteurs appartenant à l'isonorme et la sixième ligne donne la longueur moyenne du code de phase correspondant. Cette dernière est la longueur d'un code d'Huffman réalisé en prenant comme hypothèse l'équiprobabilité des événements sur une isonorme du réseau.

Pour illustrer la quantification de l'étape 30, on va donner un exemple. Un vecteur de coordonnées (0,6; -1,1; 1,7; 0,1) est quantifié par le vecteur (1; -1; 2; 0). La norme $L_2$ de ce vecteur vaut 6. En se reportant à la Fig. 2, on peut constater que le codage de sa norme est sur 3 bits alors que celui de sa phase est sur une longueur moyenne de 6,66 bits. Pour le codage de ce vecteur particulier, on utilise donc un code produit de longueur moyenne égale à 9,66 bits.

Dans une troisième étape 50, on calcule, toujours pour le quantificateur $Q_j$ et pour la sous-bande $SB_i$, la distorsion globale $D_{ij}$ qui est égale à la somme des distorsions $d_k$ sur les k points de la sous-bande $SB_i$ considérée ainsi que le débit global $R_{ij}$ qui résulte du codage de tous les k points de la sous-bande $SB_i$ considérée et qui est donc égale à la somme des débits $r_k$ sur tous les points de la sous-bande.

Par la boucle 20, les trois étapes 30, 40 et 50 décrites ci-dessus sont répétées pour l'ensemble des N quantificateurs $Q_j$.

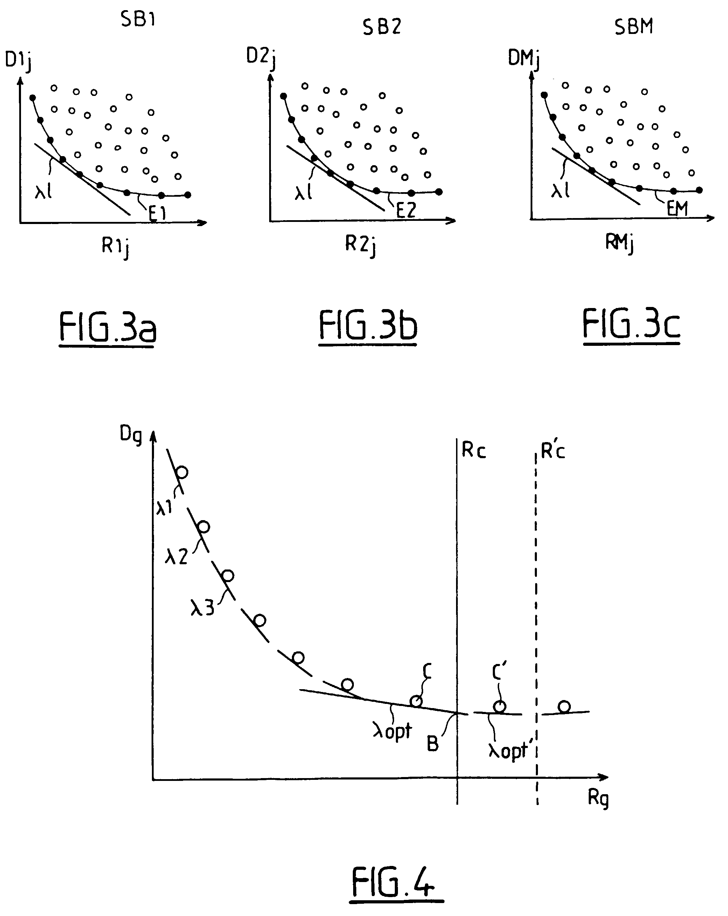

Chaque couple ($D_{ij}$, $R_{ij}$) obtenu à l'étape 50 peut être représenté par un point dans un graphe dont l'ordonnée représente la distorsion globale $D_{ij}$ pour le quantificateur $Q_j$ dans la sous-bande $SB_i$ et l'abscisse le débit global $R_{ij}$ pour le même quantificateur $Q_j$ dans la même sous-bande $SB_i$. On a représenté de tels graphes aux Figs. 3a, 3b et 3c pour les sous-bandes $SB_1$, $SB_2$ et $SB_M$.

Dans l'étape suivante 60, on recherche, pour la sous-bande $SB_i$, l'enveloppe convexe du nuage de points du graphe donnant la distorsion globale $D_{ij}$ en fonction du débit global $R_{ij}$ (Figs. 3a à 3b). Elle est obtenue point par point en recherchant, parmi toutes les droites de pente 1 donnée qui passent respectivement par les points du nuage, celle qui a l'ordonnée à l'origine la plus faible et en considérant alors le point du nuage par lequel passe cette droite.

On notera que cette ordonnée minimise la fonction objective suivante:

$$\min_{q_{ij}} D_{ij} + \lambda\ R_{ij}$$

dans laquelle $D_{ij}$ et $R_{ij}$ représentent respectivement la distorsion globale et le débit global dans la $i^{ème}$ sous-bande $SB_i$ pour le $j^{ème}$ quantificateur $Q_{ij}$.

Cette opération est recommencée pour un ensemble donné de valeurs de pente $\lambda$.

On obtient ainsi pour la sous-bande $SB_i$, un ensemble de valeurs $\lambda_1$ déterminant chacune une droite tangente à la courbe enveloppe $E_i$ (i = 1 à M) du nuage de points, et ce en un point qui minimise, pour un débit donné $R_{ij}$, la distorsion $D_{ij}$. Chacun de ces points est appelé point optimal.

Par la boucle 10, les étapes précédentes 30 à 60 sont recommencées pour l'ensemble des sous-bandes $SB_1$ à $SB_M$. On calcule alors pour les sous-bandes $SB_1$ à $SB_M$ et pour l'ensemble des valeurs $\lambda_1$ , les courbes enveloppes $E_1$ à $E_M$ ainsi que les points optimaux qui appartiennent à ces courbes enveloppes $E_1$ à $E_M$. Les points optimaux sont pochés sur les Figs. 3a à 3c.

Dans l'étape 70 suivante, on détermine pour chaque valeur $\lambda_1$, le débit global Rg ainsi que la distorsion globale Dg et ce de la manière suivante:

$$Dg = D_{1j1} + D_{2j2} + ... + D_{MjM} \text{ pour tous les points}$$

optimaux appartenant aux sous-bandes $SB_1$ à $SB_M$ et respectivement calculés à partir des quantificateurs optimaux dans les sous-bandes $SB_1$ à $SB_M$ appelés ici $Q_{j1}$ à $Q_{jM}$, et

$Rg = R_{1j1} + R_{2j2} + ... + R_{MjM}$ pour les mêmes points optimaux.

L'ensemble des couples (Dg, Rg) est représenté dans un graphe à la Fig. 4 pour l'ensemble des valeurs $\lambda_1$.

A l'étape 80, on recherche ensuite le point de la courbe (Dg, Rg) obtenue à l'étape 70 précédente dont le débit est inférieur au débit Rc dit débit cible et qui en est le plus proche. Le débit cible Rc est préalablement initialisé au débit souhaité Rd. On notera qu'il s'agit du point appartenant à la droite de pente $\lambda_{opt}$. dont le point B d'abscisse correspondant au débit souhaité Rd a une ordonnée maximale. Le point B maximalise la fonction suivante:

$$\max_{\lambda_1} D_g + \lambda_1 (R_g - R_d)$$

qui trouve une solution pour $\lambda_1 = \lambda_{opt}$

Le point optimal C appartient donc à la droite d'équation suivante:

$$Dg + \lambda_{opt} Rg$$

où $\lambda_{opt}$ est déterminé à l'étape précédente.

Ce point C associé à la pente $\lambda_{opt}$ permet d'établir la combinaison optimale de quantificateurs $Q_{ij}$ des différentes sous-bandes $SB_i$, et ainsi d'établir les vecteurs quantifiés du réseau de quantification. Les coordonnées de ces vecteurs dans le réseau de quantification donneront les valeurs de quantification. Comme mentionné ci-dessus, ces coordonnées sont des coordonnées polaires qui sont formées d'une première valeur qui est la norme du vecteur considéré et d'une seconde valeur qui est la phase du même vecteur.

On vient de décrire ce qui fait l'objet des procédés classiques de quantification vectorielle sur réseau.

La présente invention est basée sur la constatation selon laquelle le coût de codage d'un vecteur n'est pas identique pour des isonormes voisines du réseau. Par exemple, un vecteur de norme 16 dans un réseau $D_4$ de norme $L_2$ se code avec moins de bits qu'un vecteur de norme 12 ou de norme 20. Si l'on se reporte à la Fig. 2, on peut constater qu'un vecteur de norme 16 se code en moyenne sur 8,66 bits alors qu'un vecteur de norme 12 se code en moyenne sur 9,66 bits ou de norme 20 sur 12,22 bits. Cette constatation provient du fait que certaines sphères d'un réseau $D_4$ de norme $L_2$ sont plus denses que d'autres ce qui entraîne une longueur moyenne de code pour un vecteur, notamment pour la phase, qui est plus importante.

L'invention tire profit de cette constatation pour améliorer, pour un débit souhaité Rd, la distorsion globale Dg qui résulte de la quantification.

Ainsi, pour optimiser le processus de quantification mentionné ci-dessus, c'est-à-dire pour faire le choix d'un vecteur de projection sur le réseau qui donne un débit le plus proche possible du débit souhaité Rd tout en optimisant la distorsion globale Dg, l'invention consiste à rechercher, dans l'étape 90, pour chacun des points quantifiés et, parmi ses voisins dans une zone prédéterminée, le point qui fournit le meilleur compromis, c'est-à-dire celui qui minimise la fonction objective suivante:

$$d + \lambda_{opt} r$$

où d et r sont respectivement la distorsion et le débit associés au vecteur considéré.

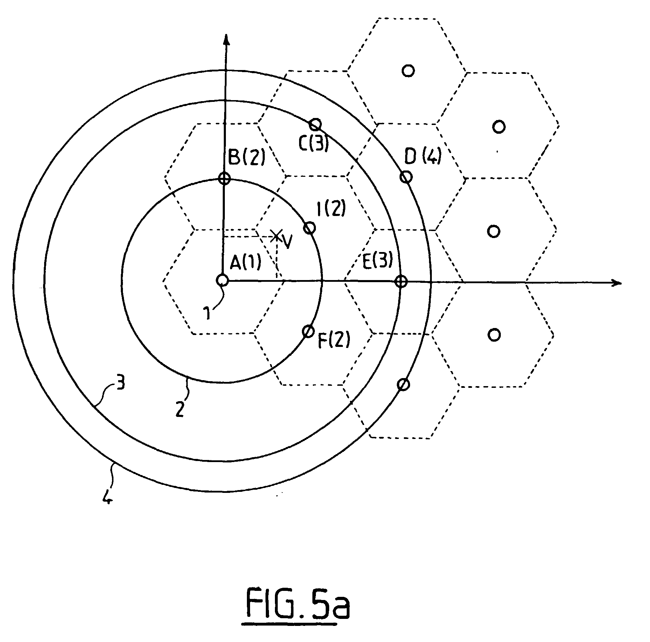

Pour illustrer l'étape 80, on a considéré, à la Fig. 5a, un point V de coordonnées (1, 0,9). On a également considéré une quantification sur un réseau $A_2$ de norme $L_2$. On a supposé que le processus de quantification décrit ci-dessus donne comme vecteur de quantification optimal le point 1 (V3, 1). Les points A, B, C, D, E, et F sont les voisins immédiats du point 1 dans le réseau $A_2$.

Dans le tableau de la Fig. 5b, on a représenté pour chacun des points I, A, B, C, D, E, et F la distorsion d, le débit r ainsi que le résultat de la fonction objective $d + \lambda_{opt} r$.

Les débits sont calculés à l'aide de la méthode décrite ci-dessus qui a donné un $\lambda_{opt}$ de 0,6.

On peut constater que c'est le point A qui minimise la fonction objective $d + \lambda_{opt} r$ dont la valeur est égale à 4,08. C'est donc lui qui sera choisi. Le nouveau débit r et la nouvelle distorsion d diffèrent de ceux qui ont été précédemment trouvés. Le débit r est inférieur et la distorsion d toujours plus élevée.

Le résultat de l'étape 90 est donc un ensemble de vecteurs quantifiés qui diffère de l'ensemble des vecteurs quantifiés trouvés précédemment. La distorsion globale Dg, somme des distorsions affectant les vecteurs quantifiés, est plus forte, mais, le débit globale Rg a diminué.

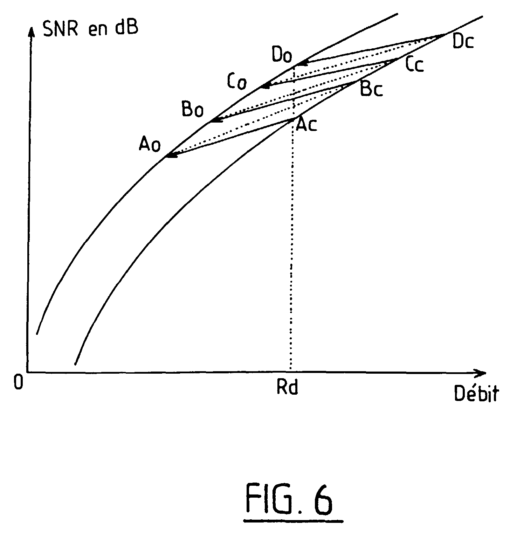

On a représenté sur la Fig. 6 un graphe montrant le rapport signal sur bruit en fonction du débit global Rg. La grandeur signal sur bruit est une fonction de l'inverse de la distorsion Dg.

Dans ce graphe, on voit qu'un procédé classique donne le point Ac et qu'un procédé selon l'invention donne le point Ao.

Il peut arriver que la diminution du débit global Rg ne soit pas satisfaisante. Aussi, l'invention propose-t-elle les étapes supplémentaires suivantes.

On incrémente à l'étape 110 le débit cible Rc d'une certaine quantité $\Delta r$. A la Fig. 4, le nouveau débit cible Rc devient Rc'. Puis, on détermine à l'étape 80 le nouveau point C et le nouveau coefficient $\lambda_{opt}$ résultant de ce nouveau débit cible Rc. Sur la Fig. 4, ce sont les points C' et le coefficient $\lambda_{opt'}$ qui sont déterminés. Une troisième boucle 120 est donc mise en place.

Sur la Fig. 6, on voit qu'un second calcul permet d'obtenir, dans le graphe donnant le signal sur bruit en fonction du débit, le point Bc pour lequel le débit Rg est supérieur au débit souhaité Rd avec une distorsion Dg inférieure (Rapport Signal/Bruit supérieur).

Pour chaque vecteur quantifié, on détermine, alors à l'étape 90, les points qui diminuent la fonction objective $d + \lambda_{opt}\, r$, puis on calcule le débit global Rg et la distorsion globale Dg. Sur le graphe de la Fig. 6, le point Bo est alors obtenu.

Le processus de la boucle 120 ci-dessus décrit est répété jusqu'à ce que soit obtenu un point dans le graphe Dg (Rg) dont le débit Rg est égal au débit souhaité Rd. A la Fig. 6, ce point est le point Do.

On remarquera que pour ce point, bien que le débit soit sensiblement égal à celui du point Ac, la distorsion est plus faible (le rapport Signal/Bruit est plus élevé).

Utilisée dans le cadre d'un codeur d'images en sous-bandes, la mise en oeuvre du procédé de l'invention apporte, par rapport à une mise en oeuvre d'un procédé classique, un gain d'environ 0,5 dB pour un même débit Rd.

Le procédé de l'invention est interrompu à l'étape 100 lorsque, après réévaluation des vecteurs quantifiés effectuée à l'étape 70, le débit obtenu est proche du débit souhaité Rd, c'est-à-dire inférieur ou égal à Rd.

On notera que la même procédure peut s'appliquer dans le cas d'un quantificateur utilisant une pondération psychovisuelle, selon laquelle on effectue des pondérations pour le calcul des distorsions ce qui permet d'introduire un débit plus fort dans les bandes de basses fréquences où l'énergie est forte. Cette pondération est bénéfique pour la qualité de l'image. Celle-ci appliquée en particulier aux sous-bandes permet d'atténuer fortement les effets gênants introduits par les différentes opérations de filtrage et connus sous le nom de *ringing.*

La recherche des vecteurs à l'étape 60 consiste maintenant à minimiser la fonction objective suivante:

$$\min_{q_{ij}} W_i\, D_{ij} + \lambda\, R_{ij}$$

Les étapes modifiées 70 et 80 consistent à minimiser la fonction objective suivante:

$$\min D_{gw} + \lambda\, R_g$$

dans laquelle $D_{gw}$ est la distorsion globale pondérée et $R_g$ le débit global qui sont respectivement calculés selon les expressions suivantes:

$$D_{gw} = S_i\, W_i\, D_{ij} \text{ et } R_g = S_i\, R_{ij}$$

dans lesquelles l'indice i porte sur les sous-bandes $SB_i$, $W_i$ est la pondération dans la sous-bande $SB_i$, et $D_{ij}$ est la distorsion globale pour une sous-bande $SB_i$ et un quantificateur j. Le terme $W_i$ est un terme calculé suivant des critères psychovisuels.

A l'étape 90, on cherche le meilleur compromis entre le débit r et la distorsion psychovisuelle pondérée $d_w$ où

$$d_w = W_i\, d \text{ avec } W_i \text{ la pondération dans la sous-}$$

bande $SB_i$ où se trouve le point considéré.

En résumé, l'affectation de pondérations psychovisuelles vient tout simplement modifier les mesures de distorsions $D_{ij}$, $D_g$ et d suivant les sous-bandes $SB_i$. Elle sera toujours basée sur l'erreur quadratique mais multipliée par un terme $W_i$ qui sera en général décroissant à mesure que les sous-bandes $SB_i$ représenteront les hautes fréquences.

On pourra, à titre d'exemple, se reporter à l'article intitulé "Weighted optimum bit allocations to orthogonal transforms for picture coding" écrit par B. Macq dans la revue IEEE transactions on selected areas in communications, 10(5):875-883 du juin 1992 pour la détermination de ces pondérations $W_i$.

**Revendications**

1. Procédé de quantification vectorielle sur réseau contrainte en débit, ledit procédé consistant à associer à un ensemble de points représentatifs de grandeurs caractéristiques d'un signal à quantifier un ensemble de points d'un réseau, dits points quantifiés, les coordonnées polaires de chacun desdits points quantifiés étant associées à un code, caractérisé en ce qu'il consiste à déterminer, parmi les points du réseau se trouvant dans un voisinage prédéterminé de chaque point quantifié, celui qui fournit le meilleur compromis exprimé en une relation prédéterminée entre la distorsion $\underline{d}$ résultant de la quantification dudit point quantifié et le débit r déterminé à partir de la longueur dudit code affecté audit point quantifié, et à retenir, comme points quantifiés pour le codage, ceux qui correspondent auxdits points déterminés.

2. Procédé de quantification vectorielle sur réseau contrainte en débit, ledit procédé consistant:

   a) à associer à un ensemble de points représentatifs de grandeurs caractéristiques d'un signal à quantifier une pluralité d'ensembles de points, les points desdits ensembles appartenant respectivement à une pluralité de réseaux,
   b) à déterminer, parmi la pluralité de réseaux, celui qui minimise la distorsion globale résultant de la quantification sous contrainte d'un débit global prédéterminé,
   c) à retenir comme points quantifiés ceux qui forment l'ensemble de points associés appartenant audit réseau ainsi déterminé à l'étape b), et
   d) à former un code par codage des coordonnées polaires de chacun desdits points quantifiés, caractérisé en ce qu'il consiste encore:
   e) à déterminer, parmi les points du réseau se trouvant dans un voisinage prédéterminé de chaque point quantifié, celui qui minimise la fonction objective suivante:

$d + \lambda_{opt} r$ où $\underline{d}$ est la distorsion résultant de la quantification dudit point quantifié, $\underline{r}$ le débit obtenu à partir de la longueur du code affecté audit point quantifié et $\lambda_{opt}$ la constante de Lagrange déterminée lors de l'étape b), et

f) à retenir comme points quantifiés ceux qui correspondent auxdits points déterminés à l'étape e).

3. Procédé de quantification vectorielle sur réseau contrainte en débit, ledit procédé consistant:

a) à associer à un ensemble de points représentatifs de grandeurs caractéristiques d'un signal à quantifier une pluralité d'ensembles de points, les points desdits ensembles appartenant respectivement à une pluralité de réseaux,

b) à déterminer, parmi la pluralité de réseaux, celui qui minimise la distorsion globale résultant de la quantification sous contrainte d'un débit global prédéterminé,

c) à retenir comme points quantifiés ceux qui forment l'ensemble de points associés appartenant audit réseau ainsi déterminé à l'étape b), et

d) à former un code par codage des coordonnées polaires de chacun desdits points quantifiés, caractérisé en ce qu'il consiste encore:

e) à déterminer, parmi les points du réseau se trouvant dans un voisinage prédéterminé de chaque point quantifié, celui qui minimise la fonction objective suivante:

$d + \lambda_{opt} r$ où $\underline{d}$ est la distorsion résultant de la quantification, $\underline{r}$ le débit obtenu à partir de la longueur du code affecté audit point quantifié et $\lambda_{opt}$ la constante de Lagrange déterminée lors du processus de minimisation de la distorsion globale sous contrainte dudit débit global prédéterminé.

f) à retenir comme points quantifiés ceux qui correspondent auxdits points déterminés,

g) à recalculer la constante de Lagrange $\lambda_{opt}$ afin de minimiser la distorsion globale sous contrainte d'un débit global augmenté d'une quantité prédéterminée,

h) à recommencer les étapes e), f) et g) jusqu'à ce que le débit global obtenu soit égal au débit global désiré.

4. Procédé selon la revendication 1, 2, 3 ou 4, caractérisé en ce que ledit signal à quantifier est subdivisé en une pluralité de sous-signaux.

5. Procédé de quantification vectorielle sur réseau contrainte en débit, ledit procédé consistant:

a) à associer à un ensemble de points représentatifs de grandeurs caractéristiques de chacun desdits signaux du signal à quantifier une pluralité d'ensembles de points, les points desdits ensembles appartenant respectivement à une pluralité de réseaux,

b) à déterminer parmi les réseaux de projection des sous-signaux ceux qui minimisent la distorsion globale résultant de la quantification sous contrainte d'un débit global prédéterminé,

c) à retenir comme points quantifiés ceux qui forment les ensembles de points appartenant auxdits réseaux ainsi déterminés à l'étape b), et

d) à former un code par codage des coordonnées polaires de chacun desdits points quantifiés, caractérisé en ce qu'il consiste encore:

e) à déterminer, parmi les points du réseau se trouvant dans un voisinage prédéterminé de chaque point quantifié, celui qui minimise la fonction objective suivante:

$d + \lambda_{opt} r$ où $\underline{d}$ est la distorsion résultant de la quantification dudit point quantifié, $\underline{r}$ le débit obtenu à partir de la longueur du code affecté audit point quantifié et $\lambda_{opt}$ la constante de Lagrange déterminée lors de l'étape b), et

f) à retenir comme points quantifiés ceux qui correspondent auxdits points déterminés à l'étape e).

6. Procédé de quantification vectorielle sur réseau contrainte en débit, ledit procédé consistant:

a) à associer à un ensemble de points représentatifs de grandeurs caractéristiques de chacun desdits signaux du signal à quantifier une pluralité d'ensembles de points, les points desdits ensembles appartenant respectivement à une pluralité de réseaux,

b) à déterminer parmi les réseaux de projection des sous-signaux ceux qui minimisent la distorsion globale résultant de la quantification sous contrainte d'un débit global prédéterminé,

c) à retenir comme points quantifiés ceux qui forment les ensembles de points appartenant auxdits réseaux ainsi déterminés à l'étape b), et

d) à former un code par codage des coordonnées polaires de chacun desdits points quantifiés, caractérisé en ce qu'il consiste encore:

e) à déterminer, parmi les points du réseau se trouvant dans un voisinage prédéterminé de chaque point quantifié, celui qui minimise la fonction objective suivante:

$d + \lambda_{opt} r$ où $\underline{d}$ est la distorsion résultant de la quantification, $\underline{r}$ le débit obtenu à partir de la longueur du code affecté audit point quantifié et $\lambda_{opt}$ la constante de Lagrange déterminée lors du processus de minimisation de la distorsion globale sous contrainte dudit débit global prédéterminé.

f) à retenir comme points quantifiés ceux qui correspondent auxdits points déterminés,

g) à recalculer la constante de Lagrange $\lambda_{opt}$ afin de minimiser la distorsion globale sous contrainte d'un débit global augmenté d'une quantité prédéterminée,

h) à recommencer les étapes e), f) et g) jusqu'à ce que le débit global obtenu soit égal au débit global désiré.

7. Procédé selon la revendication 4, caractérisé en ce que pour le processus de minimisation de la distorsion globale sous contrainte du débit global, on effectue une pondération de la distorsion $\underline{d}$ affecté à chaque point quantifié différente selon que le point est représentatif d'un sous-signal ou d'un autre sous-signal.

$$I = 1 \quad 11$$

$$J = 1 \quad 21$$

$$\text{Quantification} \quad Qj \quad 30$$

$$d, r \quad 40$$

$$Dij = \lessapprox d_k$$
$$Rij = \lessapprox r_k \quad 50$$

$$j = j+1 \quad 22$$

non $\quad j > N \quad 23$

$$Dij \; ; \; Rij$$
$$\lambda 1 \quad 60$$

$$I = I+1 \quad 12$$

non $\quad I > M \quad 13$

$$Dg , Rg \quad 70$$

$$C, \lambda opt \; pour \; Rc \quad 80$$

$$90$$

$$100 \quad Rc < Rd \quad \text{non}$$

oui

$$Rc = Rc + \Delta r \quad 110$$

10

20

120

## FIG.1

| évènement | 1 | 2 | 3 | 4 | 5 | 6 | 7 | 8 | 9 | 10 |
|---|---|---|---|---|---|---|---|---|---|---|
| fréquence | 20 | 15 | 14 | 13 | 10 | 7 | 5 | 3 | 2 | 1 |
| norme $L_2$ | 0 | 2 | 4 | 6 | 8 | 12 | 16 | 20 | 24 | 28 |
| long. du code norme | 2 | 3 | 3 | 3 | 3 | 3 | 4 | 5 | 6 | 6 |
| nb de vecteurs | 1 | 24 | 24 | 96 | 24 | 96 | 24 | 144 | 96 | 192 |
| long. du code indice | 0 | 4.66 | 4.66 | 6.66 | 4.66 | 6.66 | 4.66 | 7.22 | 6.66 | 7.66 |

# FIG. 2

| point | X | Y | n° sphère | débit: r | distorsion:d | d + $\lambda$opt r |
|---|---|---|---|---|---|---|
| I | $\sqrt{3}$ | 1 | 2 | 5.66 | 0.526 | 5.97 |
| A | 0 | 0 | 1 | 3. | 1.81 | 4.08 |
| B | 0 | 2 | 2 | 5.66 | 2.21 | 6.98 |
| C | $\sqrt{3}$ | 3 | 3 | 6.66 | 4.94 | 9.62 |
| D | $2\sqrt{3}$ | 2 | 4 | 7.66 | 7.28 | 12.03 |
| E | $2\sqrt{3}$ | 0 | 3 | 6.66 | 6.88 | 10.78 |
| F | $\sqrt{3}$ | −1 | 2 | 5.66 | 4.14 | 8.14 |

# FIG. 5b

11

FIG.3a

FIG.3b

FIG.3c

FIG.4

## FIG.5a

FIG. 6